# FASCICULE DE BREVET EUROPEEN

(11) **EP 2 269 307 B1**
(45) Date de publication et mention de la délivrance du brevet: **29.08.2012**
(21) Numéro de dépôt: 09733654.9
(22) Date de dépôt: 09.04.2009
(51) Int. Cl.: H03K 7/08

(54) **PROCÉDÉ DE GÉNÉRATION D'UN SIGNAL ANALOGIQUE GÉNÉRÉ PAR UN SIGNAL PWM ET SYSTÈME GÉNÉRANT UN TEL SIGNAL**
VERFAHREN ZUR ERZEUGUNG EINES DURCH EIN PWM-SIGNAL ERZEUGTEN ANALOGSIGNALS UND SYSTEM ZUR ERZEUGUNG EINES SOLCHEN SIGNALS
METHOD FOR GENERATING AN ANALOG SIGNAL GENERATED BY PWM SIGNAL, AND SYSTEM GENERATING SUCH SIGNAL

(30) Priorité: 14.04.2008 FR 0852498
(43) Date de publication de la demande: 05.01.2011
(73) Titulaire: Thomson Licensing, 92130 Issy-les-Moulineaux (FR)
(72) Inventeur: MACE, Philippe, F-35000 Rennes (FR); GUITTON, Xavier, F-35250 Chasne sur Illet (FR); BENEZETH, Philippe, 35510 Cesson-Sevigné (FR)
(74) Mandataire: Schmidt-Uhlig, Thomas
(86) Numéro de dépôt international: PCT/EP2009/002642
(87) Numéro de publication internationale: WO 2009/127361

(56) Documents cités:
- EP-A- 1 575 171
- US-A1- 2005 110 668
- US-B1- 6 593 864

## Description

La présente invention concerne un procédé de génération d'un signal analogique généré à partir d'un signal PWM et un système générant un tel signal.

Dans le domaine de la commande de processus électrique, il est nécessaire de produire des signaux analogiques à partir de données numériques. Un moyen simple consiste à utiliser un convertisseur numérique analogique, DAC en abrégé un exemple pour un DAC est présenté dans le document US 2005/0110668 A1. Une unité centrale commande le convertisseur en introduisant dans un registre d'entrée une valeur numérique d'une précision déterminée. La précision analogique est d'autant plus grande que la valeur numérique de contrôle du DAC possède de bits. On trouve couramment dans le commerce des DAC avec des registres 16 bits, l'unité centrale peut introduire 65536 valeurs différentes pour une tension variant de 0 volts à 10 volts, un DAC 16 bits génère deux valeurs consécutives avec un écart de 0,15 millivolt, c'est-à-dire avec une précision de 0.0015 %.

Les convertisseurs Numériques Analogique sont d'autant plus onéreux que la précision est grande et que le temps de conversion est rapide. Si on n'a pas besoin d'un temps de conversion très rapide, les signaux PWM (en Anglais « Pulse Width Modulator ») permettent de fournir une tension analogique à partir d'une grandeur numérique. Un signal PWM est un signal numérique comportant deux états « 0 » et « 1 », ce signal est périodique et produit par division d'une horloge de base. Au cours d'une période, la durée au cours de laquelle le signal est à 1 est réglable. Par convention, le rapport cyclique correspond au rapport entre le temps où la durée du signal est à « 1 » sur le temps total de la période du signal. Prenons par exemple un générateur de signal PWM ayant un registre de programmation de 8 bits dans lequel la valeur « 1 » est programmée, le signal numérique obtenu est à « 1 » pendant une seule impulsion de base et à « 0 » pendant les 255 impulsions de base suivante. La sortie numérique du signal PWM est connectée à un circuit intégrateur RC qui va lisser le signal périodique. On obtient alors une valeur continue qui peut être amplifiée pour commander un moteur par exemple.

Les applications des signaux PWM pour commander des équipements nécessitant une grandeur électrique analogique en entrée sont très nombreuses. Typiquement, on peut réguler un moteur, l'intensité d'une lampe, régler la puissance d'un amplificateur, etc. On en trouve dans les décodeurs de télévision pour contrôler la vitesse du ventilateur. En effet, ces appareils électroniques consomment une importante énergie en fonctionnement normal. Cette énergie se transforme en chaleur qui se concentre dans les appareils habituellement fermés. Si elle n'est pas évacuée cette chaleur provoque un vieillissement accéléré des composants électroniques finissant par une détérioration irréversible. Pour éviter cela, un ventilateur est disposé à proximité d'ouïes pratiquées dans la coque du décodeur pour accélérer les échanges avec l'extérieur et améliorer le refroidissement. Mais l'utilisation à pleine vitesse d'un ventilateur est bruyante. Si l'appareil est placé dans une chambre, le niveau sonore peut être gênant. L'expérimentation a montré que ce n'est pas tant la vitesse qui est audible mais la variation de vitesse. Lorsque les valeurs sont introduites dans le générateur de PWM et qu'une tension continue est ainsi produite, le passage d'une valeur à la valeur suivante est audible, surtout lorsque cette variation intervient régulièrement comme c'est le cas pour un système de régulation. Les caractéristiques des ventilateurs varient d'un appareil à l'autre. De ce fait le système de commande doit fournir des commandes dans une plage de commande étendue et donc une bonne précision sur l'ensemble de cette plage.

Pour améliorer la précision du signal de commande, une solution consiste à augmenter le nombre de bits du registre qui contrôle la durée au cours de laquelle le signal est à « 1 ». Par exemple si ce registre est de 12 bits, la précision passe alors à 1/4096 = 0,025%. Mais un générateur de PWM à 12 bits est plus onéreux qu'un générateur PWM 8 bits, de plus avec la même fréquence de base la période est 16 fois plus longue, donc il est plus lent à réagir.

Une autre solution consiste à faire varier à la fois la période et le rapport cyclique. Pour cela, les générateurs de signaux PWM sont dotés de deux registres de contrôles l'un pour programmer la durée du signal périodique, c'est la période, notée « PER ». L'autre registre programme la durée, notée « T_ON » au cours de laquelle le signal est à »1 ». Le rapport cyclique est le résultat du rapport T_ON / PER, il est toujours inférieur à 1 puisque T_ON est toujours inférieur à PER. La valeur de la grandeur analogique générée est directement proportionnelle au rapport cyclique. Pour un générateur PWM de 8bits, en modifiant à la fois les valeurs PER et T_ON, on obtient beaucoup plus de 256 valeurs possibles, et donc, on dispose d'un très grand nombre de couples permettant au final de générer autant de valeurs de tension différentes.

En respectant la règle : T_ON ≤ PER, on obtient :
Si PER = 255, alors 256 valeurs sont possible pour T_ON.
Si PER = 254, alors 255 valeurs sont possible pour T_ON.
Si PER = 253, alors 254 valeurs sont possible pour T_ON.
Si PER = 2, alors 3 valeurs sont possible pour T_ON (0, 1 ou 2).
Si PER = 1, alors deux valeurs sont possible pour T_ON (0 ou 1) : le signal est alors continuellement à « 0 » ou « 1 ».

La valeur nulle pour PER n'a pas de sens.

Le nombre possible de couples est le résultat d'une suite arithmétique, dont la formule est Σ = 255 x ((1 + 255) / 2) = 32640 couples (T_ON ; PER) différents.

On constate que certaines valeurs décimales obtenues en effectuant le rapport T_ON / PER sont identiques, par exemple : 1 / 2 = 2 / 4 = 4 / 8 = 8 / 16 = 16 / 32 = 32 / 64 = 64 / 128. Le calcul démontre qu'il existe 19947 couples (T_ON ; PER) produisant des valeurs décimales différentes ce qui génère autant de niveaux analogiques différents. Ces 19947 valeurs décimales sont comprises entre 0 et 1 et on peut supposer que n'importe quelle valeur décimale serait produite avec une précision minimale de 1/19947. Malheureusement, les précisions varient considérablement d'une valeur à l'autre.

En effet, en organisant les 19947 valeurs décimales générées par tous les couples (T_ON ; PER) dans une liste par valeurs croissantes, on constate que les écarts entre deux valeurs consécutives varient considérablement. Dans la majorité des cas, les écarts entre les valeurs décimales sont de 0.000016, ce qui produit une précision de 1/62000 environ mais dans une certaine zone de la liste, l'écart augmente brusquement et peut s'élever à 0.001961, ce qui fait baisser la précision à 1/510. Lorsque l'on veut produire une variation régulière de valeurs analogiques, un tel écart entraîne un défaut de linéarité. Cette brusque montée de l'écart entre deux rapports cycliques est dû au fait que les rapports T_ON / PER fournissent des valeurs décimale discrètes qui n'offrent pas un même écart entre elles.

Le document US 2005/110668 - CHIN DOUGLAS décrit une façon d'améliorer la précision d'un DAC. Une tension Vd déterminée est générée à l'entrée du PWM. Le générateur de PWM fournit un signal ayant deux niveaux : 0 volt et Vd selon un rapport cyclique variable. Le signal fourni par le PWM est ensuite filtré pour générer une tension continu qui dépend de la valeur Vd et du rapport cyclique du PWM, ce qui permet un réglage fin de la tension de sortie. Ce document n'envisage pas que certaines valeurs de périodes et de rapport cyclique génèrent une grande imprécision, et qu'il y aurait intérêt à ne pas les utiliser.

Le document US 6 593 864 - REILLY Timothy décrit un générateur PWM dont le signal est intégré pour fournir une tension analogique. Un circuit de compensation permet de réduire la dérive dûe à la température au fil du temps. La tension en sortie de l'intégrateur est comparé à une valeur de référence, et si l'écart est important, un état est appliqué à l'entrée Up/Down d'un compteur pour modifier les paramètres du PWM (réf. 22) de façon à garder le même niveau de sortie analogique dans le temps. Ce document n'envisage pas que certaines valeurs de périodes et de rapport cyclique génèrent une grande imprécision, et qu'il y aurait intérêt à ne pas les utiliser.

Le document EP 1 575 171 - PATRA PATENT décrit un générateur PWM qui est modulé par un circuit électronique générant une forme d'onde cyclique et synchonisée avec la période du PWM. Ce circuit électronique rajoute une modulation au signal PWM, ce qui permet globalement d'améliorer la précision. Ce document n'envisage pas que certaines valeurs de périodes et de rapport cyclique génèrent une grande imprécision, et qu'il y aurait intérêt à ne pas les utiliser.

La présente invention permet donc de diminuer l'effet de non linéarité dues au fait que certaines valeurs de périodes et de rapport cyclique génèrent de l'imprécision et de pouvoir ainsi_produire à partir d'un signal PWM des valeurs analogiques avec une grande précision.

Un des objets de la présente invention est un procédé de génération d'une pluralité de signaux analogiques générés à partir d'une pluralité de signaux PWM, comprenant une étape de calcul d'une valeur de commande pour contrôler la tension du signal analogique généré, chaque valeur de commande étant associée à une première valeur de période (PER) et une première valeur de rapport cyclique (T_ON), le rapport entre la première valeur de rapport cyclique et la première valeur de période étant une valeur décimale la plus proche de la valeur de commande, ledit signal PWM étant électriquement intégré pour produire le signal analogique ;
caractérisé en ce qu'au cours de la génération des signaux analogiques, lorsque l'écart entre la valeur de commande et la valeur décimale associée est supérieur à une valeur de seuil, alors le procédé comporte une étape d'application (5.5) d'une seconde valeur de période (PER) et d'une seconde valeur de rapport cyclique (T_ON) produisant un signal PWM dont le signal électriquement intégré est décalé d'une amplitude prédéterminée, et une étape d'activation (5.4) d'un dispositif analogique générant un décalage du signal analogique généré à partir du signal PWM, l'amplitude du décalage du signal analogique produit à partir du signal PWM étant identique et de sens contraire à celui produit par l'application des secondes valeurs de période (PER) et de rapport cyclique (T_ON).

De cette manière, si la valeur de commande ne peut correspondre de façon précise à un couple de rapport cyclique et de période donné, alors en effectuant un décalage dans les valeurs de couples pour rechercher un couple de secondes valeurs de rapport cyclique et de période générant une amplitude donnée et en commandant un décalage analogique de même amplitude et de sens contraire, on obtient la valeur de commande précise attendue.

Selon un premier perfectionnement, l'étape d'application de secondes valeurs de période et de rapport cyclique, et l'étape d'activation d'un dispositif analogique générant un décalage sont exécutées lorsque l'écart entre la valeur du signal électriquement intégré et la valeur théorique obtenue à partir de la valeur de commande est supérieur à une valeur de seuil. De cette manière, il est possible de paramètrer le déclenchement du décalage.

Selon un perfectionnement, l'utilisateur peut introduire une valeur de seuil à comparer avec l'écart afin de déterminer s'il faut commander un décalage. Cela ajoute plus de souplesse et permet d'éviter de trop nombreux décalages si la précision désirée est moyenne. Selon un autre perfectionnement, la décision d'exécuter les deux décalages se compensant mutuellement est déterminée à l'avance pour toutes les valeurs de commandes. Avantageusement, la décision se présente sous la forme d'un indicateur enregistré pour chaque valeur de commande à appliquer. De cette manière, la décision de commander un décalage est immédiatement prise.

Selon un autre perfectionnement, les exécutions de l'étape d'application de secondes valeurs de période et de rapport cyclique et de l'étape d'activation d'un dispositif analogique générant un décalage du signal analogique sont décalées dans le temps. De cette manière, le moyen de décalage le plus lent démarre le premier de sorte que l'autre moyen va rapidement compenser l'écart sans que cela génère un artefact trop important. Selon ce perfectionnement, l'étape d'activation du dispositif analogique générant un décalage du signal analogique s'exécute à la fin de la première période au cours de laquelle les secondes valeurs de période et de rapport cyclique sont appliquées. De cette façon, la première période de PWM est déjà programmée et commence à produire un décalage lorsque le décalage du signal analogique s'effectue un peu plus tard mais comme il est plus rapide, les effets vont mutuellement et dynamiquement se réduire.

Selon un autre perfectionnement, si le dispositif analogique générant un décalage du signal analogique applique immédiatement l'amplitude, alors consécutivement à l'étape d'activation du dispositif analogique générant un décalage du signal analogique, les premières valeurs de période et de rapport cyclique appliquées sont majorées pour prendre en compte le retard de l'établissement dû à l'intégration du signal PWM, de façon à limiter le brusque écart généré par le décalage analogique. De cette manière, il est possible de compenser les artefacts générés lors de l'activation du dispositif analogique qui possède un effet immédiat alors que le signal analogique produit par les secondes valeurs de période et de rapport cyclique est plus lent à s'établir du fait de la constante de temps du circuit intégrateur.

Selon un autre perfectionnement, le dispositif de génération du signal PWM dispose d'un circuit de sélection de la valeur du décalage du signal analogique parmi une pluralité de valeurs prédéterminées. De cette façon, on peut obtenir plusieurs valeurs de décalages analogiques et ainsi une meilleure précision. Selon un autre perfectionnement, un dispositif d'auto-apprentissage permet de calculer la valeur du décalage du signal analogique de façon que cette valeur soit identique à celle produite par l'application des autres valeurs de période et un rapport cyclique produisant un signal PWM dont le signal électriquement intégré est décalé. De cette façon, il est possible de calibrer le signal à partir d'un fonctionnement autonome de l'appareil et ainsi améliorer la précision intrinsèque à chaque appareil.

Un autre objet de la présente invention est un dispositif de génération d'une pluralité de signaux analogiques générés à partir d'une pluralité de signaux PWM, comportant une unité centrale calculant une valeur de commande pour contrôler la tension du signal analogique généré, chaque valeur de commande étant associée à une première valeur de période (PER) et une première valeur de rapport cyclique (T_ON),le rapport entre la première valeur de rapport cyclique et la première valeur de période étant une valeur décimale la plus proche de la valeur de commande, ledit dispositif (D) de génération comportant un moyen d'intégration du signal PWM pour produire un signal analogique ;
caractérisé en ce qu'il comporte un moyen de génération (M) de secondes valeurs de période (PER) et de rapport cyclique (T_ON) pour produire un autre signal PWM dont le signal électriquement intégré est décalé d'une amplitude prédéterminée, et un moyen de décalage (R3) du signal généré à partir du signal PWM et électriquement intégré produisant un décalage dont l'amplitude est identique et de sens contraire à celle produite par le moyen de génération (M) de secondes valeurs de période (PER) et de rapport cyclique (T_ON) ; le moyen de génération (M) de secondes valeurs de période (PER) et de rapport cyclique (T_ON) et le moyen de décalage (R3) du signal généré à partir du signal PWM étant active au cours de la génération des signaux analogiques, lorsque l'écart entre la valeur de commande et la valeur décimale associée est supérieur à une valeur de seuil.

D'autres caractéristiques et avantages de la présente invention ressortiront de la description des exemples de réalisation qui vont suivre, pris à titre d'exemples non limitatifs, en référence aux figures annexées dans lesquelles :
- la figure 1 représente une coupe d'un appareil électronique selon un exemple de réalisation de l'invention,
- la figure 2 illustre un système de génération d'un signal analogique variable selon un exemple préféré de réalisation,
- la figure 3 présente un exemple de table de correspondance permettant d'extraire des couples de période et de rapport cyclique afin de générer un signal analogique variable,
- la figure 4 présente une courbe des niveaux d'imprécision des valeurs hexadécimales de commande allant de 0000 à 65536 en décimal,
- la figure 5 présente un ordinogramme des étapes permettant de fournir un signal analogique précis, selon un exemple de réalisation,
- la figure 6 montre un exemple de schéma électronique permettant de réaliser un décalage analogique appliqué à un signal produit par un générateur de signaux PWM.
- la figure 7 montre un exemple de schéma électronique où l'application du décalage analogique s'effectue en se synchronisant avec l'application du décalage numérique.

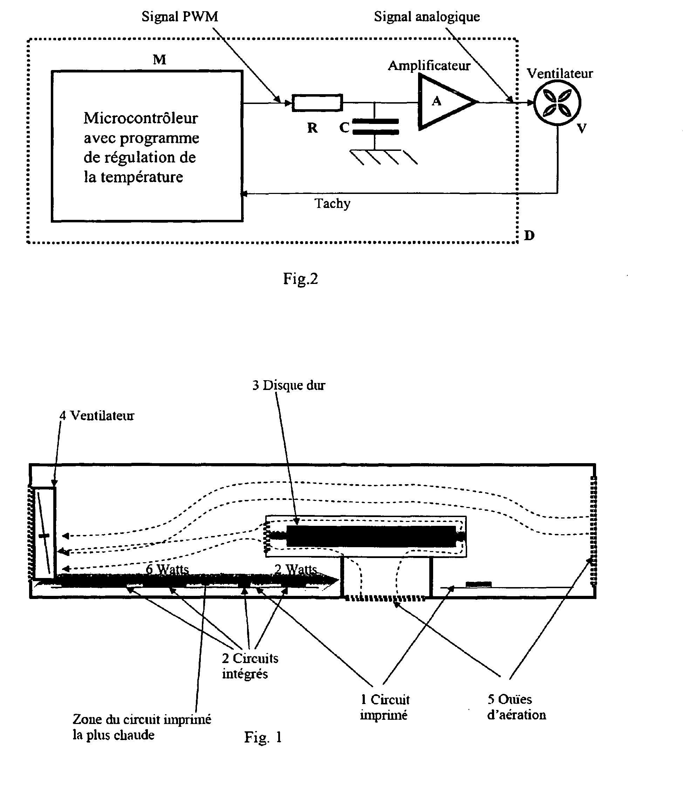

La figure 1 décrit en coupe un appareil électronique, un décodeur de télévision par exemple. L'appareil comporte un circuit imprimé 1 sur lequel des circuits électroniques 2 sont disposés. Un disque dur 3 permet de mémoriser des données, notamment des oeuvres audiovisuelles de longue durée. Les circuits 2 et le disque dur 3 consomment beaucoup d'énergie et dégagent de la chaleur. Par exemple, l'unité centrale du décodeur 2 libère typiquement une énergie d'environ 6 watts. De ce fait, certaines zones du décodeur, marquées en gris sur la figure 1, sont plus chaudes que d'autres. Un ventilateur 4 extrait l'air chaud de l'intérieur du décodeur. Deux ouïes de ventilation 5 découpées dans la coque du décodeur permettent deux entrées d'air frais. Des flèches courbes montrent le passage des flux d'air. Le nombre, la position et la taille des ouïes sont des éléments importants d'une bonne ventilation, ces paramètres étant bien connus de l'homme du métier.

La figure 2 illustre un dispositif de génération D d'un signal analogique permettant de contrôler la vitesse d'un ventilateur V selon un exemple préféré de réalisation. Cette figure est applicable à tout système de génération d'un signal analogique qui reçoit en entrée une valeur numérique et fournit en sortie un signal PWM. Dans l'exemple de réalisation décrit, l'unité de gestion M est un des circuits 2 de la carte ou une partie d'un circuit 2, sa fonction est de maintenir la vitesse du ventilateur la plus proche possible d'une vitesse de consigne. L'unité de gestion M dispose d'une entrée numérique pour la réception des signaux représentatifs de la vitesse du ventilateur (ces signaux sont généralement appelés « Tachy ») et d'une sortie de commande pour le contrôle du ventilateur 4, noté « V » sur la figure 2. Le signal Tachy est un signal impulsionnel, chaque impulsion correspondant à une partie de rotation du ventilateur. En fonction du signal Tachy, l'unité de gestion 6 calcule la vitesse du ventilateur V et effectue d'éventuelles corrections pour maintenir la vitesse le plus proche possible de la valeur de consigne.

Le dispositif de génération D génère un signal PWM pour commander la vitesse du ventilateur. Le signal numérique est converti en un signal analogique en utilisant un moyen d'intégration, typiquement un filtre passe bas constitué d'une résistance R et d'un condensateur C. Puis le signal analogique est amplifié, à l'aide d'un transistor ou d'un circuit d'amplification A. La tension analogique appliquée peut varier entre 0 et 12 Volts, mais généralement le ventilateur ne tourne pas pour une tension inférieure à 5 volts environ, et il devient trop bruyant si on dépasse 9 volts. De ce fait, la plage utile de valeurs de commande du moteur varie entre 41% et 75 %, ce qui confirme la nécessité d'avoir une bonne précision dans cette plage assez étroite. Dans le contexte de l'invention, la durée du signal périodique PER et la durée au cours de laquelle le signal est à « 1 » T_ON sont programmables.

Selon un premier mode simple de réalisation, le système de génération du signal analogique calcule des valeurs de commande sur 16 bits pour commander le ventilateur. Le système de génération dispose d'une table de correspondance enregistrée en mémoire qui, pour chaque valeur hexadécimale de commande fournit un couple (T_ON ; PER) susceptible de produire cette valeur de commande. Cette table de 65536 valeurs est une liste ordonnée de couples (T_ON ; PER). Comme cela a été dit précédemment, 19947 valeurs différentes de rapport cycliques sont possibles, de ce fait, certaines valeurs de couple peuvent être associée à une même valeur de commande.

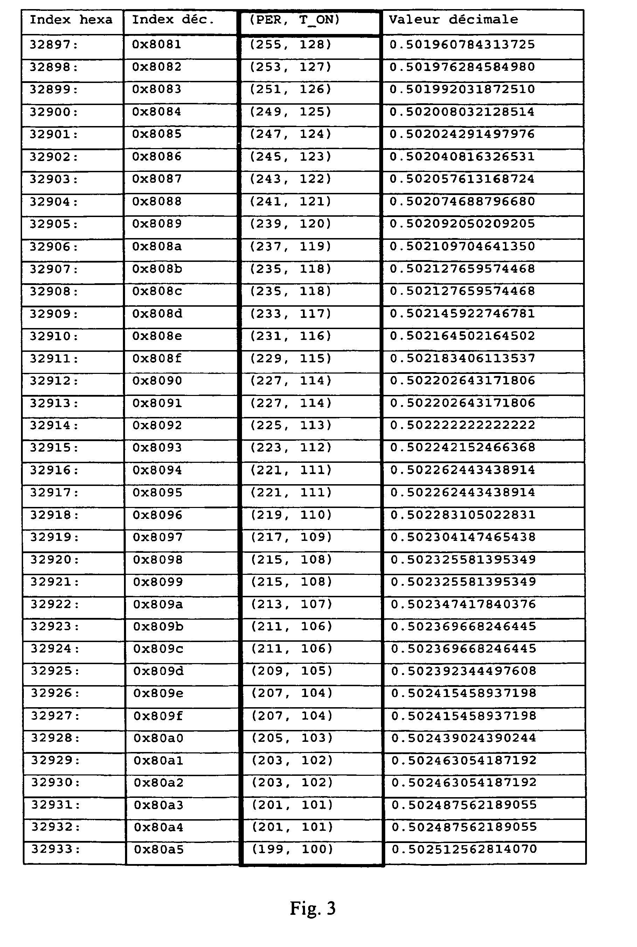

La table de la figure 3 est un exemple de table de correspondance. Supposons que le système de génération du signal analogique calcule une valeur de commande 8096H (32918 en décimal), la table fournit les valeurs PER = 219 et T_ON = 110, le système programme les deux registres du PWM avec ces valeurs. Il est également possible de réduire la table pour que le nombre de valeurs d'entrée soit un nombre égal à une plus faible puissance de 2 que 16, par exemple 2 puissance 14 ou 2 puissance 12. Certains couples (T_ON ; PER) vont alors disparaître car les valeurs décimales associées sont très proches d'autres valeurs qui restent dans la table. La zone mémoire occupée par la table est ainsi optimisée.

La plupart des microcontrôleurs manipulent des données sur 16 bits, nous garderons pour la suite du document une table de correspondance indexé par une valeur sur 16 bits. Cette table contient donc 65536 valeurs.

Nous constatons à l'aide de la table de la figure 3 que deux valeurs consécutives de commande sont généralement associées à deux couples (T_ON ; PER) différents. Mais ce n'est pas toujours le cas, par exemple pour les valeurs de commande : 808BH et 808CH, ou : 8090H et 8091 H, ou encore : 80A3H et 80A4, la table ne fournit qu'un seul couple (T_ON ; PER). De ce fait, pour l'une des deux valeurs de commandes, la précision passe de 0.16.10⁻⁶ (= 1/65536) à 0.32.10⁻⁶ (= 1/32768). Pour d'autres valeurs, la précision chute considérablement, par exemple autour de la valeur 8000H, on trouve les valeurs de commandes et les couples (T_ON ; PER) suivants :

| Index hexa | PER / T_ON | Valeur décimale | précision |
|---|---|---|---|
| 7F7EH | (252, 126) | 0.498023715415 | 16.10-6 |
| 7F7FH - 7FBFH | (254, 127) | 0.498039215686 | 16.10-6 à 1961.10-6 |
| 7FCOH - 8040H | (255, 128) | 0.500000000000 | 16.10-6 à 1960.10-6 |
| 8041H - 8080H | (254, 128) | 0.501960784313 | 16.10-6 |
| 8081H | (252, 127) | 0.501976284584 | 16.10-6 |

Le couple (T_ON ; PER) = (252,127) est associé par la table à 126 valeurs de commandes. On voit que la précision pour certaine valeur de commande n'est plus que de 1960.10⁻⁶ = 1/510, au lieu de 1/65536 ou 1/32768, que l'on trouve généralement ailleurs. La zone des valeurs de commande comprises entre 7F7FH et 8080H est une zone d'imprécision. Soit nnnnH une valeur de commande sur 16 bits, le couple (T_ON ; PER) associé doit produire un rapport cyclique dont la valeur décimale T_ON / PER est très proche de nnnnH / 10000H. Si l'écart entre les rapports T_ON / PER et nnnnH / 10000H est trop important, la valeur de commande nnnnH associée au couple (T_ON ; PER) est imprécise. Nous verrons par la suite, comment évaluer le niveau d'imprécision. La présente invention va consister à ne pas extraire de la table un couple (T_ON ; PER) correspondant à une valeur de commande imprécise mais à effectuer un décalage numérique en utilisant une autre valeur de commande qui est précise et à appliquer un décalage analogique en modifiant un paramètre de l'amplificateur. En faisant en sorte que les deux décalages soient de même amplitude mais de sens contraires, ils vont alors s'annuler.

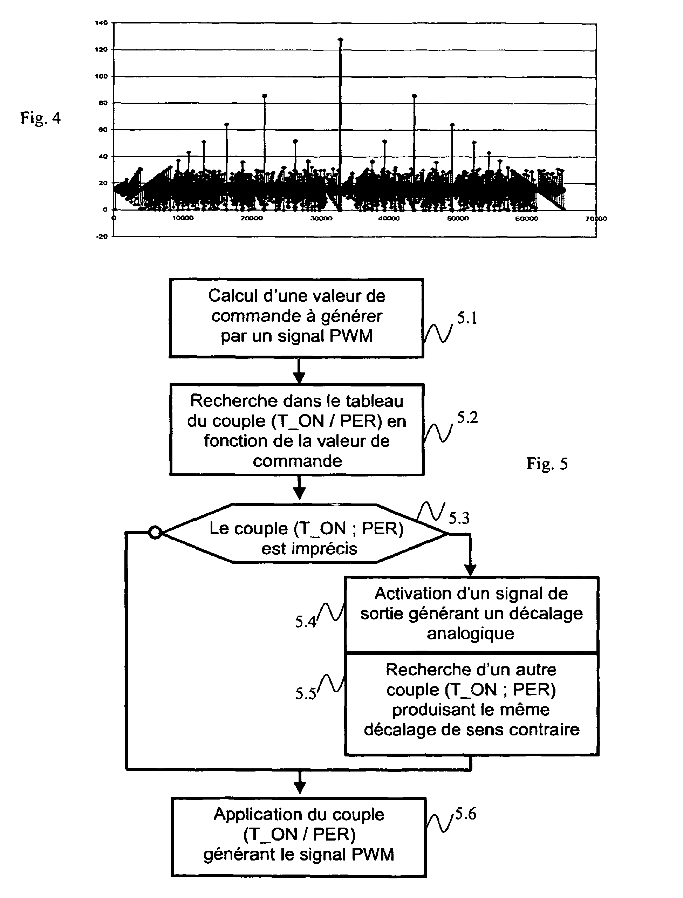

La valeur du décalage numérique à appliquer à la valeur de commande se calcule de la façon suivante. Il est d'abord utile de préciser que les valeurs de commande associées au couple (T_ON ; PER) dites imprécises sont parfaitement déterminées. La figure 4 montre le niveau d'imprécision de chaque valeur hexadécimale de commande entre 0000 et 10000H. Comme le montre la figure 4, la zone d'imprécision maximale se situe exactement à la moitié de la plage totale des valeurs de commande, c'est à dire qu'elle est centrée autour de la valeur 8000H. Puisque c'est la plage dont la valeur d'imprécision est maximale, elle sert de référence pour la correction et donc pour la détermination du décalage. On constate que les écarts entre deux valeurs de commande dans la zone de précision maximale sont de l'ordre de 16.10⁻⁶ et que la zone d'imprécision maximale comporte deux valeurs dont le total est 1961.10⁻⁶ + 1960.10⁻⁶ = 3921.10⁻⁶. La valeur 3921.10⁻⁶ représente la largeur de la plage d'imprécision maximale. Le nombre de valeurs précises que l'on pourrait obtenir dans cette plage en effectuant le rapport 3921.10⁻⁶ / 16.10⁻⁶ = est de 245. Il en résulte qu'en effectuant un décalage numérique de 245 valeurs de commande, on est sûr de s'écarter de la zone d'imprécision et, en pointant la table avec cette nouvelle valeur, d'extraire une valeur de commande précise associée à un couple (T_ON / PER). Pour une plus grande facilité d'opération, la valeur de 245 est « arrondie » à la puissance de 2 la plus proche, c'est-à-dire 256. Le décalage va donc consister à additionner 0100H à la valeur hexadécimale de commande, en d'autres termes à rajouter une unité au « Most Significant Byte » de la valeur hexadécimale de commande.

Le microcontrôleur M génère un signal PWM dont la valeur est supérieure de 0100H à celle calculée par le dispositif de génération D. Pour compenser ce décalage, un dispositif analogique est implémenté pour baisser d'autant ce niveau. Le signal PWM généré par le microcontrôleur est un signal numérique à deux niveaux de tension : 0 ou 5 volts. 0 volt est généré pour une valeur de commande de 0000 et 5 volts pour FFFFH. Un décalage de 0100H entraîne donc une variation de 5 / 256 = 0.0195 volts. Le décalage analogique consiste à baisser le niveau analogique de 19.5 millivolts.

La figure 5 est un exemple d'ordinogramme montrant les opérations permettant de générer des valeurs analogiques précises générées par un signal PWM. A l'étape 5.1, le dispositif de génération D détermine une valeur de commande. A l'aide de cette valeur de commande, le dispositif recherche dans la table le couple (T_ON ; PER) capable de générer le signal PWM qui fournit la valeur analogique la plus proche de celle demandée (étape 5.2). Dans le même temps, le dispositif lit dans la table le niveau d'imprécision associé à la valeur de commande pour laquelle un couple (T_ON ; PER) est déterminé. A l'étape 5.3, le niveau d'imprécision est testé et si ce niveau est en-dessous d'un seuil prédéterminé, alors le couple trouvé est effectivement appliqué dans le générateur de PWM. Si le niveau d'imprécision dépasse le seuil, alors le dispositif de génération D active un port de commande du microcontrôleur qui a pour effet de générer un décalage du signal analogique produit par le signal PWM (étape 5.4). De ce fait, le signal analogique va augmenter d'une certaine valeur. Le dispositif de génération D soustrait de la valeur de commande une quantité égale à celle produisant le décalage du signal analogique et obtient une nouvelle valeur de commande qui permet d'adresser la table en vue de rechercher un nouveau couple (T_ON ; PER) (étape 5.5). Avantageusement, la commande pour générer le décalage analogique et l'introduction du nouveau couple (T_ON ; PER) générant le décalage d'origine numérique ne s'effectue pas au même moment, mais l'ordre et l'intervalle de temps dépendent des constantes de temps des deux moyens de générations de décalage. Dans un mode simple de réalisation, les constantes moyennes sont calculées et les deux décalages sont appliqués l'un après l'autre en les espaçant d'une durée déterminée.

Selon un perfectionnement, et notamment dans le cas où l'on utilise un réseau résistif pour produire le décalage analogique, ce décalage est instantané, ce qui n'est pas le cas pour générer le signal analogique obtenu suite à l'application du décalage numérique. En effet, la valeur analogique correcte n'est obtenue qu'à la fin d'une période de génération de signal PWM. Donc, dans ce cas, le nouveau couple (T_ON ; PER) est d'abord appliqué au générateur PWM, puis après une durée égale à la période PER du signal PWM, le décalage analogique est appliqué. De cette façon, les décalages intervient quasiment au même moment, ce qui limite considérablement la présence d'artefact sur le signal analogique finalement produit.

Comme il a été dit précédemment, le décalage généré de façon analogique a la même amplitude que le décalage obtenu en choisissant un autre couple (T_ON ; PER) que celui correspondant à la valeur de commande calculé par le dispositif de génération. Les décalages étant de sens contraire, ils s'annulent et on obtient une valeur analogique correspondant à la valeur de commande calculée. On obtient un signal analogique précis car obtenu à partir d'une valeur de commande précise, alors que la valeur de commande initialement calculée par le dispositif de génération D ne l'est pas.

Il reste donc à définir à quel moment une valeur de commande est considérée comme imprécise, ce qui déclenche l'utilisation de décalage. Comme il a été dit précédemment, les zones d'imprécision sont parfaitement localisées, de sorte que l'on peut calculer en usine pour chaque valeur de commande nnnnH l'écart entre le rapport T_ON / PER et nnnnH / 10000H. Selon un exemple simple de réalisation, la table de correspondance contient une nouvelle colonne contenant la valeur de l'écart. Dans le cas d'un générateur PWM 8 bits, le plus faible écart est 16.10⁻⁶. L'analyse de tous les écarts montre que l'on trouve de grande succession de commande ayant un écart inférieur à 32.10⁻⁶, ce qui est le double du plus faible écart, et garantit une précision de 1/2¹⁵, ce qui est tout à fait satisfaisant. Selon un premier exemple de réalisation, le test effectué à l'étape 5.3 consiste donc à comparer la valeur de l'écart correspondant à la valeur de commande avec le seuil de 32.10⁻⁶. si la valeur de l'écart est supérieure au seuil, alors les décalages sont déclenchés. Selon une variante de réalisation, le dispositif de génération D offre la possibilité à un opérateur d'introduire une valeur de seuil à l'aide d'un clavier par exemple.

Cet exemple d'implémentation est particulièrement souple car un opérateur peut régler la valeur de seuil et ainsi augmenter le seuil en diminuant la précision, ceci pour limiter l'emploi des décalages. De plus, si le dispositif de génération D peut déterminer à l'avance que les valeurs de commande vont évoluer dans une plage de variation contenant quelques valeurs imprécises, il peut décider de déclencher un décalage de façon à faire évoluer les valeurs de commandes dans une plage ne contenant que des valeurs précises. Par exemple, supposons que pendant une longue période, le système de régulation D envoie au ventilateur des valeurs de commandes comprises 8240H et 8400H définissant ainsi la plage de régulation, et que le système constate en analysant la table qu'une zone d'imprécision commence à la valeur 83D0H. Le système de régulation décide alors de décaler d'amblée la plage de variation pour éviter de fréquentes commandes de décalages au cours de la régulation dans la plage. Le décalage va donc être commandé pour toute la plage de variation même si pour les valeurs comprises entre 8240H et 83CFF, ce ne serait pas nécessaire.

Selon une variante de réalisation, le constructeur du dispositif de régulation détermine à l'avance le déclenchement du décalage en fonction d'un seul d'imprécision. La nouvelle colonne de la table de correspondance contient alors un indicateur commandant le décalage. Cette nouvelle colonne contient la valeur du bit à appliquer sur le port de sortie commandant le décalage analogique, la valeur de ce bit déclenche également le décalage numérique.

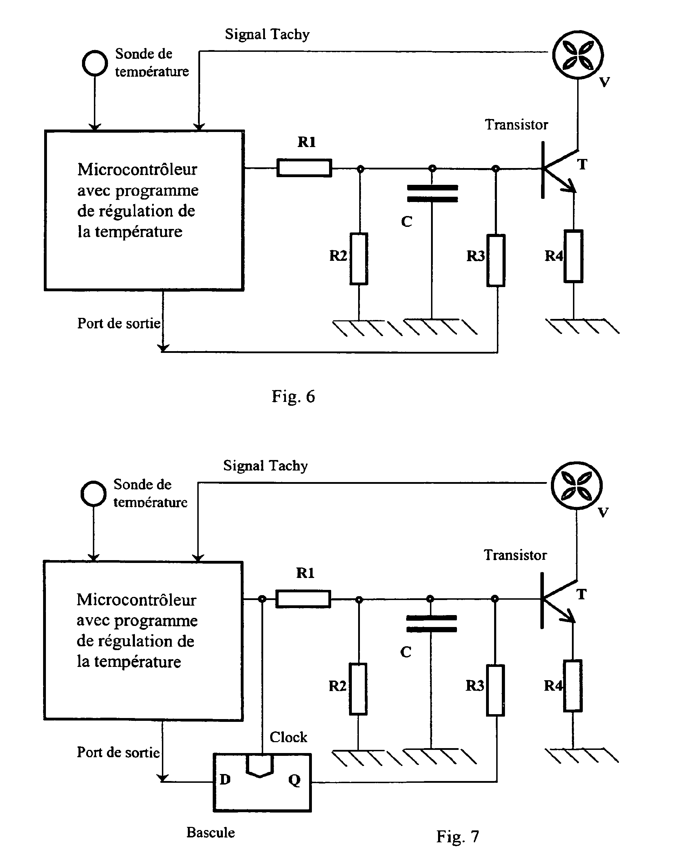

La figure 6 présente un exemple d'un schéma électrique d'implémentation d'un amplificateur intégrateur de signaux PWM apte à mettre en oeuvre la présente invention. Le réseau R1, C constitue le filtre intégrateur du signal PWM fourni par le microcontrôleur M. Le pont résistif constitué par R1 et R2/R3 polarise le transistor T. La résistance R3 est reliée à un port numérique de sortie du microcontrôleur M. La tension fournie par le port de sortie est soit 0 volt, soit 5 volts. Sans décalage analogique, le niveau du port est à + Vcc. Lorsqu'un décalage est appliqué, les valeurs de résistance R1, R2 et R3 sont déterminées pour que la tension soit abaissée de 19.5 millivolts en appliquant 0 volt sur le port de sortie. Le transistor T amplifie le signal analogique appliqué à sa base pour contrôler la vitesse du ventilateur.

Selon un autre perfectionnement, le microcontrôleur dispose de plusieurs ports de sortie pour commander des décalages analogiques ayant des amplitudes différentes. L'état des « n » ports de sortie est commandé par une nouvelle valeur de « n » bits, chaque port créant un décalage dont l'amplitude est le double de celle générée par le port contrôlé par le bit de rang immédiatement inférieur. En partant de la figure 6, on utilise plusieurs ports de sorties envoie un signal à la base du transistor à travers une résistance calibrée: R31 , R32, R33.... (non représentée sur la figure). La valeur de chaque résistance est fonction du décalage de tension à réaliser. Une fois que la largeur de la plage d'imprécision maximale est calculée, le premier port qui correspond au bit le plus significatif, doit générer un premier décalage analogique au moins égal à la largeur de plage d'imprécision maximale. Le second port qui correspond au bit immédiatement moins significatif, génère un second décalage moitié moins important que le premier. Et ainsi de suite, l'expérience montre que l'on obtient d'excellents résultats avec 3 ports de sortie, et donc 3 bits ce qui permet sept valeurs de décalage analogique. Dans le cas où la valeur hexadécimale de commande programmée par le dispositif de génération D est imprécise, la programmation des états de sorties des ports qui génèrent le décalage analogique s'effectue en fonction de la largeur de la plage d'imprécision mesurée pour cette valeur de commande. Plus la plage d'imprécision est grande, plus le décalage doit être grand pour commander des mesures à partir de couple (T_ON ; PER) précis associé à une valeur de commande.

Selon la variante de réalisation où le constructeur du dispositif définit dans la table de correspondance un indicateur commandant le décalage, cet indicateur, la nouvelle colonne contient la valeur des bits à appliquer sur les ports de sortie commandant le décalage analogique. L'amplitude du décalage numérique est fonction de ladite valeur. Avantageusement, le constructeur du dispositif dispose également dans la nouvelle colonne de la table la valeur à additionner à la valeur de commande. Si la valeur de commande des ports déclenchant le décalage est égal à « 0000», alors la valeur à additionner pour provoquer un décalage numérique est également « 0 ».

Selon un autre perfectionnement, la figure 7 présente un exemple d'un schéma électrique d'implémentation d'un amplificateur intégrateur de signaux PWM apte à mettre en oeuvre la présente invention et doté d'un moyen de synchronisation des deux décalages. Par rapport à la figure 6, on a rajouté une bascule appliquant sur sa sortie Q l'état logique présent à son entrée D, la mise à jour s'effectuant sur un front montant du signal PWM. Par convention, le front montant du signal PWM termine la période. Lors de l'application d'une nouvelle valeur de commande, les valeurs T_ON et PER sont extraites de la table et appliquées au générateur de PWM. Supposons que l'application de ce nouveau couple (T_ON , PER) nécessite un décalage analogique, le port de sortie est mis à 0 volt. Le décalage analogique ne sera effectué qu'à la fin de la période du PWM, c'est-à-dire lors du front montant. De cette façon, il n'est plus utile d'attendre une durée égale à la période pour appliquer le décalage analogique, la bascule va synchroniser l'application des deux décalages. La variation du signal analogique provoqué par l'application des nouvelles valeurs T_ON et PER est parfaitement compensée par la génération du décalage analogique et ceci au même moment. De ce fait, ces deux actions concomitantes limitent la présence d'artefact au niveau du signal analogique finalement généré.

Selon un exemple d'implémentation, la génération de signaux PWM possède une fréquence de base de 20 KHz et la constante de temps choisie pour R1 et C est de 1 milliseconde. Au cours des expérimentations, on a constaté un artefact au moment de l'établissement du décalage. Cet artefact est dû au fait que le décalage analogique s'applique immédiatement sur le signal de sortie car il découle d'un réseau résistif, alors que le décalage numérique découle de l'intégration d'un signal PWM par un circuit intégrateur possédant une certaine constante de temps. Pour diminuer au maximum cet artefact et selon un perfectionnement de la présente invention, le dispositif de génération D qui connaît la constante de temps du circuit intégrateur va appliquer une succession de couple (T_ON , PER) qui va compenser le léger retard généré par le circuit intégrateur. Par exemple, on voit qu'au cours du déroulement de la durée d'une milliseconde, le signal analogique en sortie du circuit intégrateur va atteindre la valeur déterminée, Le dispositif de génération D va alors appliquer pendant les deux ou trois premières périodes de PWM une valeur avec un important écart par rapport à la valeur de commande, écart générant un décalage qui compense très vite celui du décalage analogique. Puis au cours des périodes suivantes, le dispositif de génération applique la valeur de commande extraite de la table.

Selon un autre perfectionnement, le dispositif de génération D comporte un dispositif d'auto-calibration permettant d'évaluer avec précision la valeur de décalage analogique produit par le dispositif de décalage analogique. Dans un premier temps, le microcontrôleur sélectionne une première valeur de commande située dans une zone précise et applique le couple (T_ON ; PER) extrait de la table et le décalage analogique en activant un port de sortie. A l'aide de la sonde tachymétrique, le microcontrôleur mesure la vitesse avec une précision d'au moins 5 décimales. Puis, le microcontrôleur supprime le décalage analogique et la vitesse du ventilateur diminue. Ensuite, le microcontrôleur extrait de la table les valeurs de commande immédiatement supérieures à la première et mesure la vitesse avec la même précision. Le microcontrôleur applique de nouvelles valeurs de commande tant que la vitesse mesurée n'est pas égale ou extrêmement proche à celle mesurée pour la première valeur de commande. Lorsque cette seconde valeur de commande est déterminée, le microcontrôleur calcule l'écart avec la première valeur, cet écart correspond au décalage numérique équivalent au décalage analogique.

Cette opération est effectuée pour chaque port de sortie générant un décalage de façon à ce que les valeurs absolues des décalages numériques et analogiques soient les plus proches possibles. Avantageusement, une résistance variable ou tout autre moyen manuel permettant d'ajuster le décalage est implémenté dans l'appareil. Une indication visuelle permet à un opérateur de régler le composant pour que le décalage analogique soit égal à une valeur déterminée. Si plusieurs ports de sortie sont implémentés pour générer des décalages différents, cette opération est réitérée pour chaque port.

Des personnes versées dans l'art pourront adapter la présente invention sous de nombreuses autres formes spécifiques sans l'éloigner du domaine d'application de l'invention comme revendiqué. En particulier, le système de génération peut s'adapter pour la génération de signaux de toute grandeur physique utilisée dans n'importe quel appareil électronique. Par conséquent, les présents modes de réalisation doivent être considérés à titre d'illustration mais peuvent être modifiés dans le domaine défini par la portée des revendications jointes.

## Revendications

1. Procédé de génération d'une pluralité de signaux analogiques générés à partir d'une pluralité de signaux PWM, comprenant une étape de calcul d'une valeur de commande pour contrôler la tension du signal analogique généré, chaque valeur de commande étant associée à une première valeur de période (PER) et une première valeur de rapport cyclique (T_ON), le rapport entre la première valeur de rapport cyclique et la première valeur de période étant une valeur décimale la plus proche de la valeur de commande, ledit signal PWM étant électriquement intégré pour produire le signal analogique ;
**caractérisé en ce qu'**au cours de la génération des signaux analogiques, lorsque l'écart entre la valeur de commande et la valeur décimale associée est supérieur à une valeur de seuil, alors le procédé comporte une étape d'application (5.5) d'une seconde valeur de période (PER) et d'une seconde valeur de rapport cyclique (T_ON) produisant un signal PWM dont le signal électriquement intégré est décalé d'une amplitude prédéterminée, et une étape d'activation (5.4) d'un dispositif analogique générant un décalage du signal analogique généré à partir du signal PWM, l'amplitude du décalage du signal analogique produit à partir du signal PWM étant identique et de sens contraire à celui produit par l'application des secondes valeurs de période (PER) et de rapport cyclique (T_ON).

2. Procédé de génération d'une pluralité de signaux analogiques selon la revendication 1
; **caractérisé en ce qu'**il comporte une étape d'introduction de la valeur de seuil à comparer avec ledit écart.

3. Procédé de génération d'une pluralité de signaux analogiques selon la revendication 1
; **caractérisé en ce que** la décision d'appliquer les deux décalages qui se compensent mutuellement est déterminée à l'avance pour toutes les valeurs de commande.

4. Procédé de génération d'une pluralité de signaux analogiques selon l'une quelconque des revendications précédentes ; **caractérisé en ce que** l'exécution de l'étape d'application (5.5) de secondes valeurs de période (PER) et de rapport cyclique (T_ON) et l'exécution de l'étape d'activation (5.4) d'un dispositif analogique générant un décalage du signal analogique sont décalées dans le temps.

5. Procédé de génération d'une pluralité de signaux analogiques selon la revendication 4
; **caractérisé en ce que** l'étape d'activation du dispositif analogique générant un décalage du signal analogique s'exécute à la fin de la première période où les secondes valeurs de période (PER) et de rapport cyclique (T_ON) sont appliquées.

6. Procédé de génération d'une pluralité de signaux analogiques selon l'une quelconque des revendications précédentes ; **caractérisé en ce que**, si le dispositif analogique générant un décalage du signal analogique applique immédiatement l'amplitude prédéterminée, alors consécutivement à l'étape d'activation du dispositif analogique générant un décalage du signal analogique, les premières valeurs de période (PER) et de rapport cyclique (T_ON) appliquées sont majorés pour pendre en compte le retard de rétablissement du signal analogique dû à son intégration, de façon à limiter le brusque écart généré par le décalage analogique.

7. Procédé de génération d'une pluralité de signaux analogiques selon l'une quelconque des revendications précédentes ; **caractérisé en ce qu'**il comporte une étape de sélection de la valeur du décalage du signal analogique parmi une pluralité de valeurs prédéterminées.

8. Procédé de génération d'une pluralité de signaux analogiques selon l'une quelconque des revendications précédentes ; **caractérisé en ce qu'**il comporte une étape d'auto-apprentissage pour calculer la valeur du décalage du signal analogique de façon que cette valeur soit identique à celle produite par l'application des secondes valeurs de période (PER) et de rapport cyclique (T_ON) produisant un signal PWM dont le signal électriquement intégré est décalé.

9. Dispositif (D) de génération d'une pluralité de signaux analogiques générés à partir d'une pluralité de signaux PWM, comportant une unité centrale calculant une valeur de commande pour contrôler la tension du signal analogique généré, chaque valeur de commande étant associée à une première valeur de période (PER) et une première valeur de rapport cyclique (T_ON),le rapport entre la première valeur de rapport cyclique et la première valeur de période étant une valeur décimale la plus proche de la valeur de commande, ledit dispositif (D) de génération comportant un moyen d'intégration du signal PWM pour produire un signal analogique ;
**caractérisé en ce qu'**il comporte un moyen de génération (M) de secondes valeurs de période (PER) et de rapport cyclique (T_ON) pour produire un autre signal PWM dont le signal électriquement intégré est décalé d'une amplitude prédéterminée, et un moyen de décalage (R3) du signal généré à partir du signal PWM et électriquement intégré produisant un décalage dont l'amplitude est identique et de sens contraire à celle produite par le moyen de génération (M) de secondes valeurs de période (PER) et de rapport cyclique (T_ON) ; le moyen de génération (M) de secondes valeurs de période (PER) et de rapport cyclique (T_ON) et le moyen de décalage (R3) du signal généré à partir du signal PWM étant activés au cours de la génération des signaux analogiques, lorsque l'écart entre la valeur de commande et la valeur décimale associée est supérieur à une valeur de seuil.

10. Dispositif (D) de génération d'une pluralité de signaux analogiques selon la revendication 9 ; **caractérisé en ce qu'**il comporte un moyen d'introduction de la valeur de seuil à comparer avec l'écart.

11. Dispositif (D) de génération d'une pluralité de signaux analogiques selon l'une quelconque des revendications 9 ou 10 ; **caractérisé en ce que** l'activation du moyen de génération (M) des secondes valeurs de période (PER) et de rapport cyclique (T_ON) et, l'activation du moyen de décalage (R3) du signal analogique généré à partir du signal PWM sont décalées dans le temps.

12. Dispositif (D) de génération d'une pluralité de signaux analogiques selon la revendication 11 ; **caractérisé en ce que** l'activation du moyen de décalage (R3) du signal analogique généré à partir du signal PWM s'effectue à la fin de la première période où les secondes valeurs de période (PER) et de rapport cyclique (T_ON) sont appliquées.

13. Dispositif (D) de génération d'une pluralité de signaux analogiques selon l'une quelconque des revendications 9 à 12 ; **caractérisé en ce qu'**il comporte un moyen de sélection de la valeur du décalage du signal analogique parmi une pluralité de valeurs prédéterminées.

14. Dispositif (D) de génération d'une pluralité de signaux analogiques selon l'une quelconque des revendications 9 à 13 ; **caractérisé en ce qu'**il comporte un moyen d'auto-apprentissage pour calculer la valeur du décalage du signal analogique de façon que cette valeur soit identique à celle produite par l'application des secondes valeurs de période (PER) et de rapport cyclique (T_ON) produisant un signal PWM dont le signal électriquement intégré est décalé.

## Claims

1. Method for generating a plurality of analogue signals generated from a plurality of PWM signals, comprising a step of computing a command value to control the tension of the generated analogue signal, each command value being associated to a first period value (PER) and to a first cyclic ratio value (T_ON), the ratio between the first cyclic ratio value and the first period value being the closest decimal value to the command value, said PWM signal being electrically integrated to produce the analogue signal;
**characterized in that** during the generation of the analogue signals, if the difference between the command value and the associated decimal value is greater than a threshold value, then the method comprises an application step (5.5) of a second period value (PER) and of a second cyclic ratio value (T_ON) producing a PWM signal for which the electrically integrated signal is shifted by a predetermined amplitude, and an activation step (5.4) of an analogue device generating a shift of the analogue signal generated from the PWM signal, the amplitude of the shift of the analogue signal produced from the PWM signal being identical and in the opposite direction to that produced by the application of second period (PER) and cyclic ratio (T_ON) values.

2. Method for generating a plurality of analogue signals according to claim 1; **characterized in that** it comprises a step for introducing the threshold value to be compared with the difference.

3. Method for generating a plurality of analogue signals according to claim 1; **characterized in that** the decision to apply the two mutually compensating shifts is determined in advance for all the command values.

4. Method for generating a plurality of analogue signals according to any one of the aforementioned claims; **characterized in that** the execution of the application step (5.5) of second period (PER) and cyclic ratio (T_ON) values, and the execution of the activation step (5.4) of an analogue device generating a shift of the analogue signal are shifted in time.

5. Method for generating a plurality of analogue signals according to claim 4; **characterized in that** the activation step of the analogue device generating a shift of the analogue signal is executed at the end of the first period during which the second period (PER) and cyclic ratio (T_ON) values are applied.

6. Method for generating a plurality of analogue signals according to any one of the aforementioned claims; **characterized in that**, if the analogue device generating a shift of the analogue signal immediately applies the predetermined amplitude, then consecutively to the activation step of the analogue device generating a shift of the analogue signal, the first period (PER) and cyclic ratio (T_ON) values applied are increased to take into account the delay in establishing the analogue signal due to its integration, in such a way as to limit the sharp difference generated by the analogue shift

7. Method for generating a plurality of analogue signals according to any one of the aforementioned claims; **characterized in that** it comprises a step for selecting the value of the shift of the analogue signal from among a plurality of predetermined values.

8. Method for generating a plurality of analogue signals according to any one of the aforementioned claims; **characterized in that** it comprises a self-learning step for calculating the value of the shift of the analogue signal so that this value is identical to the one produced by the application of the second period (PER) and cyclic ratio (T_ON) values producing a PWM signal for which the electrically integrated signal is shifted.

9. Device (D) for generating a plurality of analogue signals from a plurality of PWM signals, comprising a central unity computing a command value to control the tension of the generated analogue signal; each command value being associated to a first period value (PER) and to a first cyclic ratio value (T_ON), the ratio between the first cyclic ratio value and the first period value being the closest decimal value to the command value, the device (D) comprising a means of integrating the PWM signal to produce an analogue signal;
**characterized in that** it comprises a generation means (M) of second period (PER) and cyclic ratio (T_ON) values to produce another PWM signal whose electrically integrated signal is shifted from a predetermined amplitude, and a means (R3) of shifting the signal generated from the PWM signal and electrically integrated producing a shift whose amplitude is identical and in the opposite direction to the one produced by the generation means (M) of second period (PER) and cyclic ratio (T_ON) values; the generation means (M) of second period (PER) and cyclic ratio (T_ON) values and the means (R3) of shifting the analogue signal generated from the PWM signal are activated during the generation of the analogue signals, when the difference between the command value and the associated decimal value is greater than a threshold value.

10. Device (D) for generating a plurality of analogue signals according to claim 9, **characterized in that** it comprises a means for introducing the threshold value to be compared with the difference.

11. Device (D) for generating a plurality of analogue signals according to any one of claims 9 to 10; **characterized in that** the activation of the generation means (M) of second period (PER) and cyclic ratio (T_ON) values and, the activation of the means (R3) of shifting the analogue signal generated from the PWM signal are shifted in time.

12. Device (D) for generating a plurality of analogue signals according to claim 11; **characterized in that** the activation of the means (R3) of shifting the analogue signal generated from the PWM signal is carried out at the end of the first period during which the second period (PER) and cyclic ratio (T_ON) values are applied.

13. Device (D) for generating a plurality of analogue signals according to any one of claims 9 to 12; **characterized in that** it comprises a means for selecting the value of the shift of the analogue signal from among a plurality of predetermined values.

14. Device (D) for generating a plurality of analogue signals according to any one of claims 9 to 13; **characterized in that** it comprises a self-learning means for calculating the value of the shift of the analogue signal so that this value is identical to the one produced by the application of the second period (PER) and cyclic ratio (T_ON) values producing a PWM signal for which the electrically integrated signal is shifted.

## Patentansprüche

1. Verfahren zur Erzeugung einer Vielzahl von analogen Signalen, die von einer Vielzahl von PWM-Signalen ausgehend erzeugt werden, einen Schritt zur Berechung eines Steuerungswertes aufweisend, um die Spannung des erzeugten analogen Signals zu regeln, wobei jeder Steuerungswert einem ersten Wert einer Periode (PER) und einem ersten Wert eines Tastverhältnisses (T_ON) zugeordnet ist, wobei das Verhältnis zwischen dem ersten Wert eines Tastverhältnisses und dem ersten Wert einer Periode aus einem dezimalen Wert besteht, der dem Steuerungswert am nächsten liegt, wobei das PWM-Signal elektrisch integriert ist, um das analoge Signal zu produzieren;
**dadurch gekennzeichnet, dass** während der Erzeugung der analogen Signale, wenn die Abweichung zwischen dem Steuerungswert und dem zugeordneten dezimalen Wert größer als ein Schwellenwert ist, das Verfahren dann einen Schritt zur Anwendung (5.5) eines zweiten Wertes einer Periode (PER) und eines zweiten Wertes eines Tastverhältnisses (T_ON) umfasst, wodurch ein PWM-Signal produziert wird, dessen elektrisch integriertes Signal um eine vorbestimmte Amplitude verschoben ist, und einen Schritt zur Aktivierung (5.4) einer analogen Vorrichtung, die eine Verschiebung des von dem PWM-Signal ausgehend erzeugten analogen Signals erzeugt, wobei die Amplitude der Verschiebung des von dem PWM-Signal ausgehend erzeugten analogen Signals zu derjenigen identisch ist und in entgegengesetzte Richtung verläuft, die durch die Anwendung des zweiten Wertes einer Periode (PER) und des zweiten Wertes eines Tastverhältnisses (T_ON) produziert wird.

2. Verfahren zur Erzeugung einer Vielzahl von analogen Signalen nach Anspruch 1, **dadurch gekennzeichnet, dass** es einen Schritt zum Einführen des Schwellenwertes umfasst, der mit der Abweichung verglichen werden soll.

3. Verfahren zur Erzeugung einer Vielzahl von analogen Signalen nach Anspruch 1, **dadurch gekennzeichnet, dass** die Entscheidung, die beiden Verschiebungen anzuwenden, die sich gegenseitig aufheben, im vorhinein für alle Steuerungswerte getroffen wird.

4. Verfahren zur Erzeugung einer Vielzahl von analogen Signalen nach irgendeinem der vorhergehenden Ansprüche, **dadurch gekennzeichnet, dass** die Ausführung des Schrittes zur Anwendung (5.5) eines zweiten Wertes einer Periode (PER) und eines zweiten Wertes eines Tastverhältnisses (T_ON) und die Ausführung des Schrittes zur Aktivierung (5.4) einer analogen Vorrichtung, die eine Verschiebung des analogen Signals erzeugt, zeitlich verschoben sind.

5. Verfahren zur Erzeugung einer Vielzahl von analogen Signalen nach Anspruch 4, **dadurch gekennzeichnet, dass** der Schritt zur Aktivierung der analogen Vorrichtung, die eine Verschiebung des analogen Signals erzeugt, am Ende der ersten Periode ausgeführt wird, wenn der zweite Wert einer Periode (PER) und der zweite Wert eines Tastverhältnisses (T_ON) angewendet werden.

6. Verfahren zur Erzeugung einer Vielzahl von analogen Signalen nach irgendeinem der vorhergehenden Ansprüche, **dadurch gekennzeichnet, dass**, wenn die analoge Vorrichtung, die eine Verschiebung des analogen Signals erzeugt, sofort die vorbestimmte Amplitude anwendet, dann auf den Schritt zur Aktivierung der analogen Vorrichtung folgend, die eine Verschiebung des analogen Signals erzeugt, der angewendete erste Wert einer Periode (PER) und der angewendete erste Wert eines Tastverhältnisses (T_ON) erhöht werden, um die Verzögerung des Aufbaus des analogen Signals aufgrund seiner Integration dergestalt zu berücksichtigen, dass die durch die analoge Verschiebung erzeugte abrupte Abweichung begrenzt wird.

7. Verfahren zur Erzeugung einer Vielzahl von analogen Signalen nach irgendeinem der vorhergehenden Ansprüche, **dadurch gekennzeichnet, dass** es einen Schritt zum Auswählen des Wertes der Verschiebung des analogen Signals unter einer Vielzahl von vorbestimmten Werten umfasst.

8. Verfahren zur Erzeugung einer Vielzahl von analogen Signalen nach irgendeinem der vorhergehenden Ansprüche, **dadurch gekennzeichnet, dass** es einen Schritt zum automatischen Lernen umfasst, um den Wert der Verschiebung des analogen Signals dergestalt zu berechnen, dass dieser Wert zu demjenigen identisch ist, der durch die Anwendung des zweiten Wertes einer Periode (PER) und des zweiten Wertes eines Tastverhältnisses (T_ON) produziert wird, wodurch ein PWM-Signal produziert wird, dessen elektrisch integriertes Signal verschoben ist.

9. Vorrichtung (D) zur Erzeugung einer Vielzahl von analogen Signalen, die durch eine Vielzahl von PWM-Signalen erzeugt werden, eine Zentralprozessoreinheit umfassend, die einen Steuerungswert berechnet, um die Spannung des erzeugten analogen Signals zu regeln, wobei jeder Steuerungswert einem ersten Wert einer Periode (PER) und einem ersten Wert eines Tastverhältnisses (T_ON) zugeordnet ist, wobei das Verhältnis zwischen dem ersten Wert eines Tastverhältnisses und dem ersten Wert einer Periode aus einem dezimalen Wert besteht, der dem Steuerungswert am nächsten liegt, wobei die Vorrichtung (D) zur Erzeugung ein Mittel zur Integration des PWM-Signals umfasst, um ein analoges Signal zu produzieren;
**dadurch gekennzeichnet, dass** sie ein Mittel zur Erzeugung (M) von einem zweiten Wert einer Periode (PER) und einem zweiten Wert eines Tastverhältnisses (T_ON) umfasst, um ein weiteres PWM-Signal zu produzieren, dessen elektrisch integriertes Signal um eine vorbestimmte Amplitude verschoben ist, und ein Mittel zur Verschiebung (R3) des von dem PWM-Signal ausgehend erzeugten und elektrisch integrierten Signals, wodurch eine Verschiebung produziert wird, dessen Amplitude zu derjenigen identisch ist und in entgegengesetzte Richtung verläuft, die durch das Mittel zur Erzeugung (M) eines zweiten Wertes einer Periode (PER) und eines zweiten Wertes eines Tastverhältnisses (T_ON) produziert wird; wobei das Mittel zur Erzeugung (M) eines zweiten Wertes einer Periode (PER) und eines zweiten Wertes eines Tastverhältnisses (T_ON) und das Mittel zur Verschiebung (R3) des von dem PWM-Signal ausgehend erzeugten Signals während der Erzeugung der analogen Signale aktiviert werden, wenn die Abweichung zwischen dem Steuerungswert und dem zugeordneten dezimalen Wert höher als ein Schwellenwert ist.

10. Vorrichtung (D) zur Erzeugung einer Vielzahl von analogen Signalen nach Anspruch 9, **dadurch gekennzeichnet, dass** sie ein Mittel zur Einführung des Schwellenwertes umfasst, der mit der Abweichung verglichen werden soll.

11. Vorrichtung (D) zur Erzeugung einer Vielzahl von analogen Signalen nach irgendeinem der vorhergehenden Ansprüche 9 oder 10, **dadurch gekennzeichnet, dass** die Aktivierung des Mittels zur Erzeugung (M) des zweiten Wertes einer Periode (PER) und des zweiten Wertes eines Tastverhältnisses (T_ON) und die Aktivierung des Mittels zur Verschiebung (R3) des von dem PWM-Signal ausgehend erzeugten analogen Signals zeitlich verschoben sind.

12. Vorrichtung (D) zur Erzeugung einer Vielzahl von analogen Signalen nach Anspruch 11, **dadurch gekennzeichnet, dass** die Aktivierung des Mittels zur Verschiebung (R3) des von dem PWM-Signal ausgehend erzeugten analogen Signals am Ende der ersten Periode erfolgt, wenn der zweite Wert einer Periode (PER) und der zweite Wert eines Tastverhältnisses (T_ON) angewendet werden.

13. Vorrichtung (D) zur Erzeugung einer Vielzahl von analogen Signalen nach irgendeinem der Ansprüche 9 bis 12, **dadurch gekennzeichnet, dass** sie ein Mittel zum Auswählen des Wertes der Verschiebung des analogen Signals unter einer Vielzahl von vorbestimmten Werten umfasst.

14. Vorrichtung (D) zur Erzeugung einer Vielzahl von analogen Signalen nach irgendeinem der vorhergehenden Ansprüche 9 bis 13, **dadurch gekennzeichnet, dass** sie ein Mittel zum automatischen Lernen umfasst, um den Wert der Verschiebung des analogen Signals dergestalt zu berechnen, dass dieser Wert identisch zu demjenigen ist, der durch die Anwendung des zweiten Wertes einer Periode (PER) und des zweiten Wertes eines Tastverhältnisses (T_ON) produziert wird, wodurch ein PWM-Signal produziert wird, dessen elektrisch integriertes Signal verschoben ist.
